# EUROPEAN PATENT SPECIFICATION

(11) **EP 1 675 149 B1**
(45) Date of publication and mention of the grant of the patent: **25.02.2009**
(21) Application number: 05258071.9
(22) Date of filing: 23.12.2005
(51) Int. Cl.: H01J 17/49, H01J 17/28

(54) **Flat display apparatus**
Flachbildschirm
Ecran plat

(30) Priority: 23.12.2004 KR 2004111122; 23.02.2005 KR 2005014966; 23.02.2005 KR 2005014967
(43) Date of publication of application: 28.06.2006
(73) Proprietor: LG Electronics Inc., Seoul 150-721 (KR)
(72) Inventor: Lee, Byung Chul, Dangjin-gun (KR); Kim, Bogryong, Gum-si Gyeongsangbuk-do (KR); Hwang, Tae Soo, Gumi-si Gyeongsangbuk-do (KR)
(74) Representative: Camp, Ronald

(56) References cited:
- EP-A- 0 821 385
- EP-A- 1 641 015
- WO-A-20/04013885
- US-B1- 6 410 841
- PATENT ABSTRACTS OF JAPAN vol. 2003, no. 10, 8 October 2003 (2003-10-08) & JP 2003 162228 A (MITSUBISHI ELECTRIC CORP), 6 June 2003 (2003-06-06)

## Description

The present invention relates to a flat display apparatus. It more particularly relates to a flat display apparatus which can prevent a misdischarge and enhance the productivity.

There are various kinds of flat display apparatuses such as liquid crystal display (LCD), field emission display (FED), organic electroluminescence display, plasma display and the like. In particular, the plasma display is a device in which, when an inert gas located between a soda-lime glass front substrate and a rear substrate is discharged by a highfrequency voltage, vacuum ultraviolet radiation is generated, so that a fluorescent substance or phosphor coated therein emits visible light to display the image.

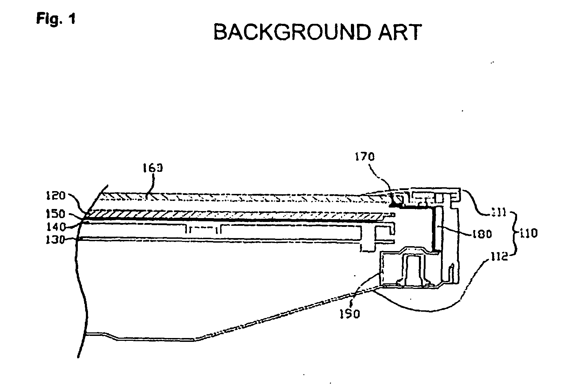

Fig. 1 is a view showing schematically a structure of a background art plasma display apparatus. As shown in Fig. 1, the plasma display comprises a case 110 including a front cabinet 111 and a back cover 112; a plasma display panel 120 for exciting the fluorescent substance; a driving unit 130 including a printed circuit board for driving and controlling the plasma display panel; a frame 140 connected to the driving unit for radiating heat generated when the plasma display apparatus is operated and for supporting the plasma display panel; and a thermally conductive sheet 150 formed between the plasma display panel and the frame for transmitting heat generated at the plasma display panel to the frame.

The plasma display also includes a filter 160 formed by adhering a film on a transparent glass substrate and provided at a front side of the plasma display panel at a predetermined interval; a finger spring gasket 170 supporting the filter and electrically connecting the metal back cover and the filter; and a module supporter 190 supporting the plasma display apparatus including a filter supporter 180 and a driving apparatus.

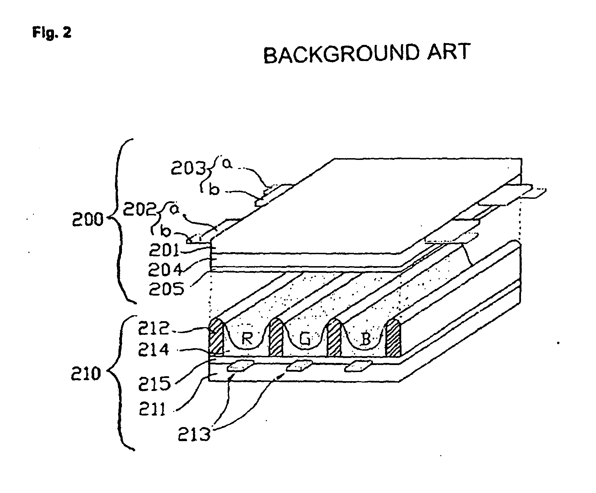

A structure of the background art plasma display panel will now be described in detail with reference to Fig. 2. In the plasma display panel, a front substrate 200 and a rear substrate 210 are combined in parallel with each other at a predetermined interval. The front substrate is formed by arranging a plurality of sustain electrode pairs, each of which includes a scan electrode 202 and a sustain electrode 203, on a front glass 201 which is a display surface on which the image is displayed. The rear substrate 210 is formed by arranging a plurality of address electrodes 213 on a rear glass 211 acting as a rear surface. The address electrodes 213 and the plurality of sustain electrode pairs 202, 203 cross each other.

In the front substrate 200, the scan electrode 202 and the sustain electrode 203 each comprise a pair of electrodes. Each of the pair of electrodes comprises a transparent electrode (a) made of transparent ITO (indium tin oxide) and a bus electrode (b) made of a metal. The scan electrode 202 and the sustain electrode 203 limit the discharge current and are covered with one or more upper dielectric layers 204 which insulate the electrode pair. A protective layer 205 on which magnesium oxide (MgO) is deposited is formed on an upper surface of the dielectric layer 204 for easily discharging.

In the rear substrate 210, stripe type (or well type) walls 212 are disposed parallel with each other for forming a plurality of discharge spaces (that is, a plurality of discharge cells). Also, a plurality address electrodes 213 which perform the address discharge to generate vacuum ultraviolet radiation are disposed parallel with the walls 212. An upper surface of the rear substrate 210 is coated with red, green and blue (R,G,B) fluorescent substances 214 emitting visible radiation for displaying an image when the address discharge is generated. A lower dielectric layer 215 is formed between the address electrodes 213 and the fluorescent substances 214 for protecting the address electrodes 213.

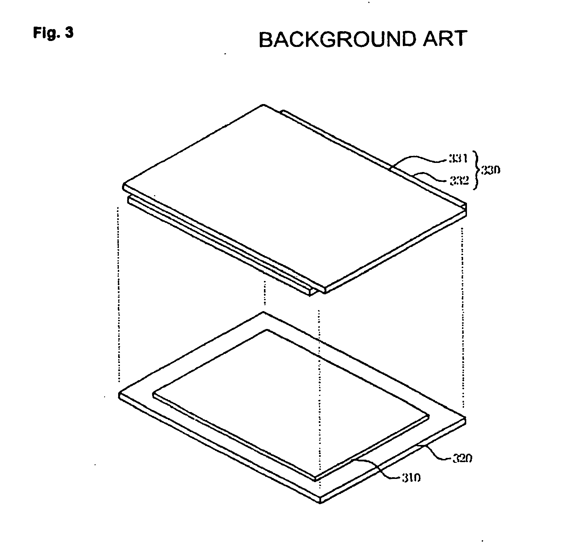

A thermally conductive sheet is formed on a rear surface of the plasma display panel for transmitting heat generated from the plasma display panel, as shown in Fig. 3. The background art thermally conductive sheet 310 is formed on a frame 320, and then is adhered to a plasma display panel 330 having a front substrate 331 and a rear sheet 332. The thermally conductive sheet 310 makes the frame 320 adhere to the plasma display panel 330, and transmits the generated heat toward the frame 320 when the plasma display panel 330 is operated. Also, the frame 320 is adhered to the plasma display panel 330 by the thermally conductive sheet 310 to support the thermally conductive sheet 310 and radiate heat transmitted through the thermally conductive sheet 310 toward the outside.

The background art thermally conductive sheet is formed with a single sheet, and there is a drawback that the workability becomes lower. That is, when the frame is adhered to the plasma display panel by the single thermally conductive sheet, due to a large surface area of the thermally conductive sheet, an adhesive density between the thermally conductive sheet and the plasma display panel is reduced to lower the workability. If the adhesive density between the thermally conductive sheet and the plasma display panel is reduced as described above, an air layer is partially formed between the thermally conductive sheet and the plasma display panel. Such an air layer reduces the thermal conductivity, and therefore heat generated when the plasma display panel is operated cannot be radiated effectively.

PCT patent application WO 2004/013885 A2 dislcoses an image display apparatus in which a thermally conductive sheet is sandwiched between an image display panel and a supporting plate, and at least one adhesive tape having sufficient bonding strength for holding the display panel and capable of being peeled from the supporting plate when pulled at its end portion is bonded to a surface of the supporting plate that is not occupied by the thermally conductive sheet.

The present invention seeks to provide an improved flat display apparatus.

Embodiments of the present invention can provide a flat display apparatus which has an improved structure to enhance the workability.

Embodiments of the present invention can provide a flat display apparatus which reduces the manufacturing cost.

Embodiments of the present invention can provide a flat display apparatus which can suppress a temperature gradient of the flat display panel.

In accordance with the invention in its broadest aspect, a flat display apparatus comprises a display panel; a frame provided at a rear surface of the display panel; and at least two thermally conductive porous sheets located between the display panel and the frame, the thermally conductive sheets being side-by-side and spaced apart from each other.

Embodiments of the present invention can enhance the workability by improving a structure of the flat display apparatus. Also, embodiments of the present invention can be advantageous in that manufacturing cost can be reduced by improving a structure of the flat display apparatus. In addition, the temperature gradient of a flat display panel can be suppressed.

Examples of similar devices include a flat display apparatus includes a display panel, a frame provided on a rear surface of the display panel, and at least two thermally conductive sheets formed between the display panel and the frame. The thermally conductive sheets may be spaced apart from each other at predetermined distances.

The thermally conductive sheets are smaller in size than the display panel, so that edges of the thermally conductive sheets are spaced from an edge of the display panel. In one embodiment, the distance between the thermally conductive sheets is 0.1 mm to 5.0 mm. Also, in one embodiment, the thermally conductive sheets have a thickness of 0.1 mm to 2.0 mm.

The thermally conductive sheets are arranged in a longitudinal direction or a widthwise direction of the frame. In one embodiment, the thermally conductive sheet is a porous pad or porous sheet. The porous sheet may contain a foaming agent, such as urethane foam. The porous pad or the porous sheet may contain silicon material. The frame, the thermally conductive sheets and the frame may have one or more holes formed thereon.

Examples of similar devices include, a flat display apparatus includes a display panel, a frame provided on a rear surface of the display panel, and two or more thermally conductive sheets placed between the display panel and the frame. In one embodiment, the thermally conductive sheets are spaced apart from each other at a distance of approximately 0.1mm to 5.0 mm.

Examples of similar devices include a flat display apparatus includes a display panel, a frame provided on a rear surface of the display panel, and a thermally conductive sheet formed between the display panel and the frame. In one embodiment, the frame has one or more holes formed thereon.

It should be understood that the detailed description and specific examples, while indicating preferred embodiments of the invention, are given by way of illustration only, since various changes and modifications within the scope of the invention will become apparent to those skilled in the art.

Embodiments of the invention will now be described by way of non-limiting example only, with reference to the drawings in which:

Fig. 1 is a view showing schematically a structure of the background art plasma display apparatus

Fig. 2 is a view showing the background art plasma display apparatus.

Fig. 3 is a view showing schematically a thermally conductive sheet in the background art plasma display apparatus.

Fig. 4 is a view showing schematically a thermally conductive sheet in a plasma display apparatus.

Fig. 5 is a view showing schematically a modified structure of the flat display apparatus.

Fig. 6 is a view showing schematically a frame.

Fig. 7 is a view showing schematically another modified structure of the flat display apparatus.

Fig. 8a and Fig. 8b are views for illustrating a structure of the flat display apparatus.

Fig. 9a and Fig. 9b are graphs for illustrating the thermal characteristic of the flat display panel.

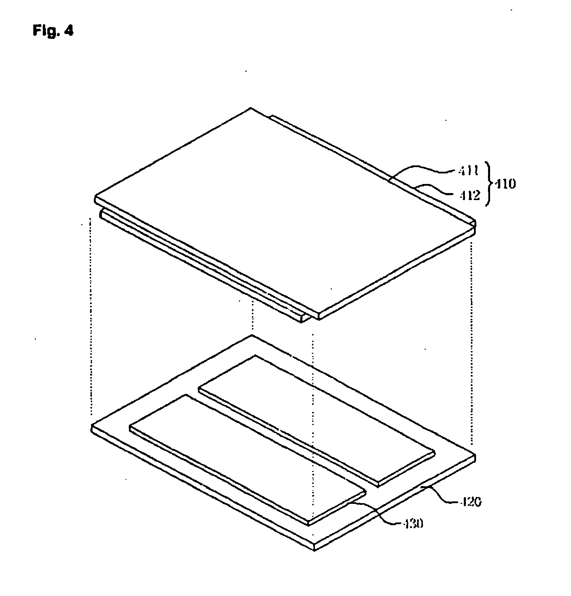

As shown in Fig. 4, a thermally conductive sheet 430 of the flat display apparatus is formed on a frame 420, and then adhered to a rear surface of a flat display panel 410.

The flat display panel 410 includes a front substrate 411 of a flat display apparatus such as a PDP, an LCD and the like, and a rear substrate 412. An image is displayed on the flat display panel 410 when the flat display apparatus is operated. The frame 420 supports the flat display panel 410 and radiates heat generated by the flat display panel 410 toward an outside when the apparatus is operated.

One surface of the thermally conductive sheet 430 is attached to the frame 420 and the other surface is attached to the flat display panel 410. The thermally conductive sheet 430 acts as a medium which transmits heat generated by the flat display panel 410 toward the frame 420 when the apparatus is operated. The thermally conductive sheet 430 is formed of at least two unit sheets which are spaced from each other at a particular distance.

As compared with the background art structure in which one thermally conductive sheet is formed on the frame, if the plurality of thermally conductive sheets 430 spaced apart from each other are formed on the frame 420 and attached to the flat display panel 410 as described above, it is possible to work with the device easily, so that a poor quality rate caused by processing tolerances can be reduced. Also, as compared with the background art structure in which one thermally conductive sheet is formed on the frame, if a plurality of the thermally conductive sheets 430 are formed on the frame 420, the formation of an air layer between the frame 420 and the thermally conductive sheets 430 can be effectively suppressed.

In addition, in the background art structure, if the thermally conductive sheet is attached to the frame in the state where the thermally conductive sheet is not aligned with the frame, the entire thermally conductive sheet needs to be removed from the frame. Contrary to the background art structure, in the structure shown in Fig. 4, although the thermally conductive sheets 430 are attached to the frame 420 in the state where one of the thermally conductive sheets 430 is not aligned with the frame 420, only the thermally conductive sheet 430 which is not aligned with the frame 420 needs to be removed. Therefore, the workability is made easier, and it is possible to reduce a loss of the thermally conductive sheet 430 caused by an inferior alignment state, so that manufacturing costs can be reduced.

Each edge of the thermally conductive sheets 430 attached to the frame 420 is located inside of a corresponding edge of the flat display panel 410 at a particular gap. As above, if the flat display panel 410 has margins formed on an upper edge section, a lower edge section and both side edge sections thereof, a sufficient tolerance can be obtained when the thermally conductive sheets 430 attached to the frame 420 are attached to the flat display panel 410, so that the workability can be enhanced. A detailed description of a distance between the thermally conductive sheets 430 will be described below with reference to the second embodiment.

In order to sufficiently transmit heat generated at the flat display panel 410 toward the frame, the thermally conductive sheets 430 may have a thickness of approximately 0.1 mm to 2.0 mm. The thickness of 0.1 mm of the thermally conductive sheets 430 is a minimum thickness for forming a sheet shape, and if the thickness exceeds 2 mm, the thermal conductivity is lowered so that the thermally conductive sheets 430 cannot sufficiently radiate the generated heat toward the outside of the frame 420 when the flat display apparatus 410 is operated.

The two or more thermally conductive sheets 430 are attached to the frame 420 in one of a longitudinal direction or a widthwise direction of the frame 420. The thermally conductive sheets 430 can be made of metal with a high thermal conductivity; however, it is preferable to use a thermally conductive tape or silicon and the like for convenience of the assembly process.

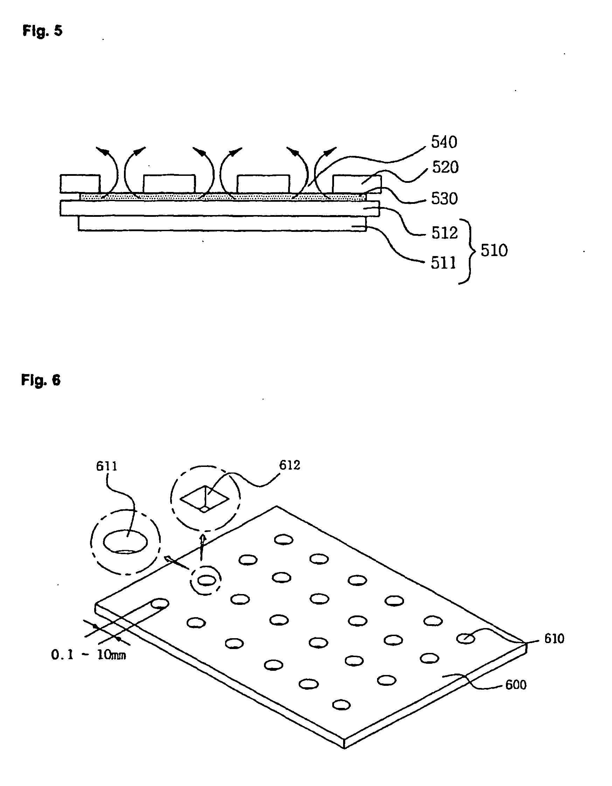

Fig. 5 is a view schematically showing another structure of the flat display apparatus according to the first embodiment, wherein a thermally conductive sheet 530 is formed on a frame 520, and then adhered to a rear surface of a flat display panel 510. The flat display panel 510 includes a front substrate 511 of a flat display apparatus such as a PDP, an LCD and the like, and a rear substrate 512. An image is displayed on the flat display panel 510 when the flat display apparatus is operated.

The frame 520 supports the flat display panel 510 and radiates heat generated at the flat display panel 510 toward an outside when the apparatus is operated. One surface of the thermally conductive sheet 530 is attached to the frame 520 and the other is attached to the flat display panel 510. The thermally conductive sheet 530 acts as a medium which transmits heat generated at the flat display panel 510 toward the frame 520 when the apparatus is operated.

The frame 520 according to the first embodiment has one or more holes 540 formed thereon. The holes 540 of the frame are formed on a section on which the thermally conductive sheet 530 is formed. With this structure, when the thermally conductive sheet 530 is attached to the flat display panel 510, any remaining air is exhausted through the holes 540 of the frame 520, and so the formation of an air layer can be effectively suppressed.

A porous pad or a porous sheet is preferably used as the thermally conductive sheet 530 so as to enable air remaining between the flat display panel 510 and the thermally conductive sheet 530 to flow toward the frame 520 through the thermally conductive sheet 530. Since the porous pad or the porous sheet or the porous sheet makes the remaining air pass toward the frame 520 and absorbs noise and vibration, the porous pad or the porous sheet prevents the noise and vibration generated when the flat display panel 510 is operated from being transmitted to the frame 520. In order to absorb the noise and vibration generated in the flat display panel 510, the porous pad or the porous sheet is made of porous material with a low density and a low hardness.

The porous pad may be made by mixing urethane foam with silicon material and then applying an adhesive on front and rear surfaces of the manufactured pad, so that the porous pad or the porous sheet is obtained. Thus, due to the urethane foam, a plurality of porosities are formed in the silicon of the pad. Acryl material may be used as the adhesive applied on the front and rear surfaces of the pad. In the porous pad or the porous sheet, a content rate of the silicon is approximately 89%, a content rate of the urethane foam is approximately 10%, and a content rate of the adhesive is approximately 1%. Air remaining between the flat display panel 510 and the thermally conductive sheet 530 flows through the porosities formed by the urethane foam, and the pad having the porosities absorbs the noise and vibration transmitted to the frame 520. Also, heat which is generated when the flat display panel 510 is operated, is transmitted to the frame 520 through the silicon contained in the porous pad or the porous sheet. Because of the porosities of the porous pad or the porous sheet, the porous pad or the porous sheet absorbs external shock. Additional details concerning an embodiment of the porous pad or the porous sheet may be found in copending US Patent Application No. 10/612,874.

As shown in Fig. 6, a frame 600 has a plurality of holes 610 formed thereon. In general, when the thermally conductive sheet 530 is attached to the flat display panel 510, an air layer is not just formed on specific areas, but is formed irregularly on the entire surface. In order to suppress the formation of an irregular air layer or to remove an air layer which has already been formed, the holes 610 are formed on a section of the frame 600 on which the thermally conductive sheet 530 is formed. At this time, the holes 610 are disposed regularly at regular intervals or disposed irregularly on the frame 600.

The shape of each hole 610 of the frame 600 can be any one of a circular shape 611, an elliptical shape, a rectangular shape 612 or a lozenge shape. That is, it is possible to modify the shape of the holes 610 of the frame 600 according to the convenience and need of the manufacturer.

The size (diameter or height/width) of the hole 610 is greater than 0.1 mm, taking a processing tolerance into consideration, and is less than 10.0 mm, taking into consideration the mechanical strength and heat-radiating efficiency of the frame 600.

On the other hand, although air can be sufficiently exhausted through the structure of another flat display apparatus according to the first embodiment, air can be exhausted more effectively in the structure of yet another flat display apparatus according to the first embodiment described below.

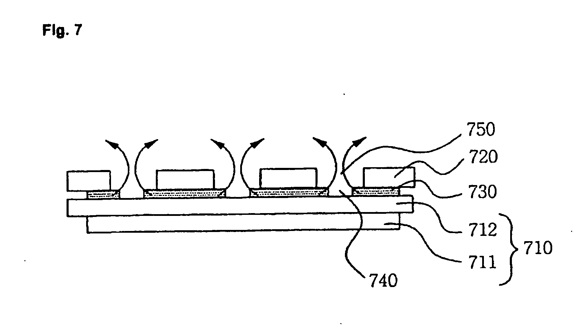

Fig. 7 is a view schematically showing another structure of the flat display apparatus wherein a thermally conductive sheet 730 is formed on a frame 720, and then adhered to a rear surface of a flat display panel 710.

The flat display panel 710 includes a front substrate 711 of the general flat display apparatus such as the PDP, the LCD and the like, and a rear substrate 712. An image is displayed on the flat display panel when the flat display apparatus is operated. A frame 720 supports the flat display panel 710 and radiates heat generated at the flat display panel 710 toward an outside when the apparatus is operated.

One surface of the thermally conductive sheet 730 is attached to the frame 720 and the other is attached to the flat display panel 710, so that the thermally conductive sheet 730 acts as a medium which transmits heat generated at the flat display panel 710 toward the frame 720 when the apparatus is operated.

Yet another thermally conductive sheet 730 has one or more holes 740 formed thereon, and at least one or more holes 750 are formed on the frame 720. The holes 740 formed on the thermally conductive sheet 730 are matched with the holes 750 formed on the frame 720, respectively. By matching the holes 740 of the thermally conductive sheet 730 with the holes 750 of the frame 720, the remaining air is exhausted through the holes 740 of the thermally conductive sheet 730 and the holes 750 of the frame 720 matched with the holes 740 of the thermally conductive sheet 730 when the thermally conductive sheet 730 is attached to the flat display panel 710.

Also, thermally conductive sheet 730 is made of the porous material so that air can be effectively exhausted through the thermally conductive sheet 730 itself and the holes 740 of the thermally conductive sheet 730.

The size (diameter or width/height) of each hole 740 of the thermally conductive sheet 730 is 0.1 mm to 5.0 mm. The minimum size of a hole 740 is 0.1 mm, taking into consideration the processing tolerance, and 5.0 mm is a maximum size of a hole 740, taking into consideration that the thermally conductive sheet 730 at a portion on which the hole 740 is formed is decreased. A size (diameter or width X height) of each hole 750 of the frame is 0.1 mm or more, taking into consideration the processing tolerance, and is 10.0 mm or less, taking into consideration a mechanical strength and a heat radiating-efficiency of the frame 720.

Also, air is exhausted smoothly by matching the holes 750 of the frame 720 with the holes 740 of the thermally conductive sheet 730. The number of holes 750 of the frame 720 is preferably the same as the number of holes 740 of the thermally conductive sheet 730, and so an efficiency of the frame 720 can be increased.

A support bracket (not shown) and a mount (not shown) may be provided on a rear surface of the frame 720 for supporting and fixing the flat display apparatus. The formation of an air layer can be suppressed by forming the holes 750 at a section of the frame 720 adjacent to a section on which it is difficult to form the hole.

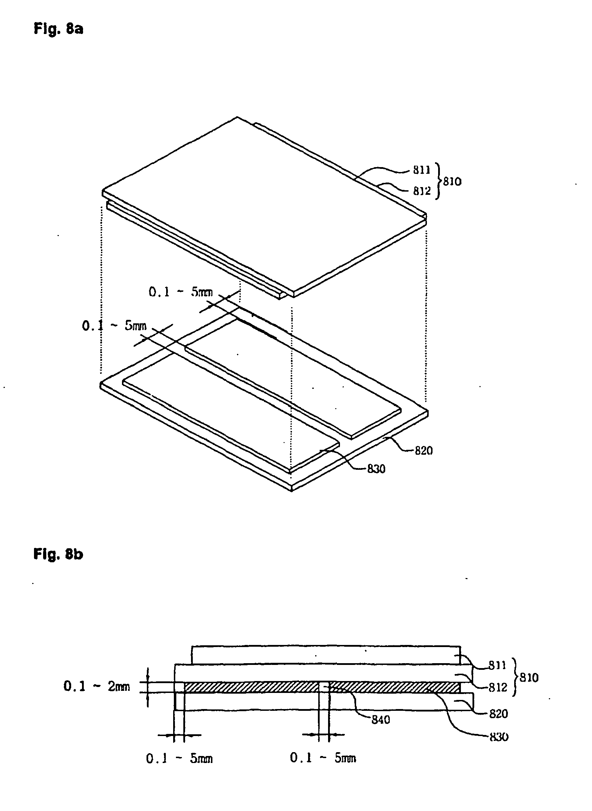

Referring to Fig. 8a and Fig. 8b, a thermally conductive sheet 830 of a flat display apparatus is formed on a frame 820, and then adhered to a rear surface of a flat display panel 810.

The flat display panel 810 includes a front substrate 811 of the general flat display apparatus such as a PDP, an LCD and the like, and a rear substrate 812. An image is displayed on the flat display panel 810 when the flat display apparatus is operated. The frame 820 supports the flat display panel 810 and radiates heat generated at the flat display panel 810 toward an outside when the apparatus is operated.

One surface of the thermally conductive sheet 830 is attached to the frame 820 and the other surface is attached to the flat display panel 810 The thermally conductive sheet 830 acts as a medium which transmits heat generated by the flat display panel 810 toward the frame 820 when the apparatus is operated. The thermally conductive sheet 830 contains a plurality of sheets, which are spaced apart from each other at certain distances.

When two or more thermally conductive sheets 830 are formed at certain distances, the workability is enhanced, the formation of an air layer is suppressed and manufacturing cost is reduced. The description is omitted since the description thereof has been set forth above regarding the first embodiment.

As shown in Fig. 8b, since the thermally conductive sheet 830 is not formed on a space section 840 between the thermally conductive sheets 830, if the flat display apparatus is operated for long time, heat generated at the flat display panel 810 cannot be transmitted sufficiently toward the frame 820. In particular, in proportion to a width of the space section 840, a temperature gradient is generated excessively on the flat display panel 810 matched with the space section 840 on which the thermally conductive sheet is not formed. Due to the temperature gradient, the misdischarge is generated in the flat display panel 810 when the flat display apparatus is operated.

That is, when the width of the space section 840 is narrow, there are drawbacks that the workability becomes lower and an occurrence ratio of an air layer is increased since it is difficult to exhaust air when the thermally conductive sheets 830 are adhered to the flat display panel 810. On the other hand, when the width of the space section 840 is wide, the misdischarge is induced due to the temperature gradient of the flat display panel 810.

It is desirable that a width of the space section 840 between the thermally conductive sheets 830 is 0.1 mm to 5.0 mm. A minimum distance of 0.1 mm takes into consideration the processing tolerance, and a maximum distance of 5.0 mm is an distance at which the misdischarge caused by the temperature gradient of the flat display panel 810 can be prevented.

Also, the thermally conductive sheets 830 are formed such that the distance between an edge of the each thermally conductive sheet 830 and an edge of the flat display panel 810 is 0.1 mm to 5.0 mm. A minimum distance of 0.1 mm takes into consideration the processing tolerance, and a maximum distance of 5.0 mm is a distance at which the misdischarge caused by the temperature gradient of the flat display panel 810 can be prevented.

The distance between an edge of the each thermally conductive sheet 830 and an edge of the display area of the flat display panel on which an image display is displayed when the flat display apparatus is operated is 5 mm or less. Thus, manufacturing cost of the thermally conductive sheet 830 can be saved.

Also, the thickness of the thermally conductive sheet 830 is 0.1 mm to 2.0 mm, and the misdischarge caused by the temperature gradient is not generated in the flat display panel 890 when the space section 840 between the thermally conductive sheets 830 is 5.0 mm or less. That is, relating to a width of the space section 840 between the thermally conductive sheets 830, a thickness of the thermally conductive sheet 830 acts as a factor which influences the temperature gradient. A minimum thickness of 0.1 mm takes into consideration the processing tolerance, and 5.0 mm is a maximum thickness at which an acceptable temperature gradient is generated. The thermal conductivity of the entire thermally conductive sheet 830 with a thickness of 2 mm is significantly reduced, thus a temperature gradient is generated if the width of the space section 840 between the thermally conductive sheets 830 is 5.0 mm or less.

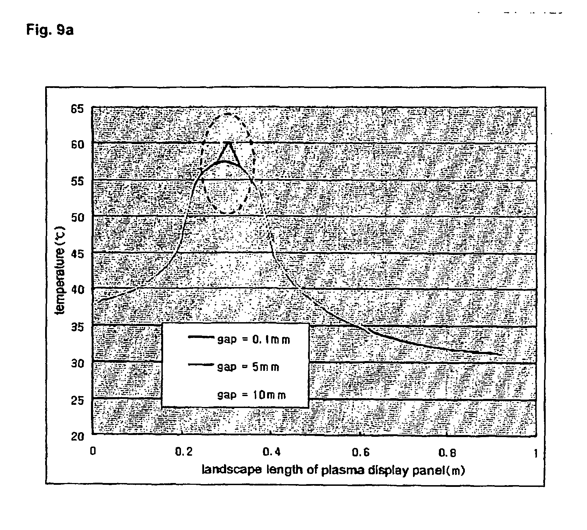

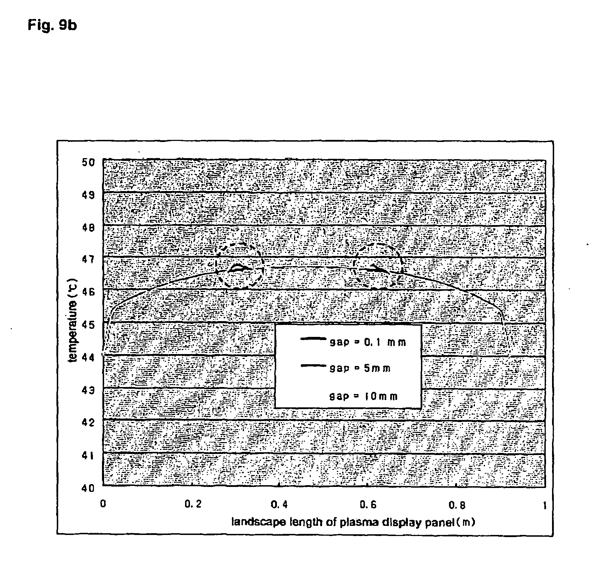

Fig. 9a and Fig. 9b are graphs for illustrating the thermal characteristic of the flat display panel. The x axis in Fig. 9a indicates each position in a widthwise direction of the flat display panel, and the y axis indicates a temperature measured at each position of the flat display panel. Two thermally conductive sheets 830 are formed on the frame 820, and a certain distance between the two thermally conductive sheets 830 is formed at a section from which the zero point is spaced apart at 0.35 m. The curves indicate changes of the temperature at the position at which the distance between the thermally conductive sheets is 0.1 mm, 5.0 mm and 10.0 mm, respectively.

The x axis in Fig. 9b indicates each position in a widthwise direction of the flat display panel, and the y axis indicates the temperature measured at each position of the flat display panel. Three thermally conductive sheets 830 are formed on the frame, and certain distances between two thermally conductive sheets 830 are formed at a section from which the zero point is spaced apart at 0.35 m and 0.65 m. The curves indicate changes of the temperature at the position at which the distance between the thermally conductive sheets is 0.1 mm, 5.0 mm and 10.0 mm, respectively.

As shown in Fig. 9a and Fig. 9b, in proportion to the distance between the thermally conductive sheets, the temperature at a section of the flat display panel corresponding to the distance between the thermally conductive sheets is increased. When the distance between the thermally conductive sheets is 5.0 mm or less, a misdischarge caused by a temperature gradient is not generated.

As described above the thermally conductive sheet is placed between the flat display panel and the frame, the thermally conductive sheet is divided into two or more sheets, and a distance is formed between the thermally conductive sheets. With this, a process for forming the thermally conductive sheet is easily performed, the formation of an air layer can be suppressed and manufacturing cost can be lowered.

Considering that an air layer is widely generated when the interval between the thermally conductive sheets is narrow and a uniformity of temperature of the flat display panel deteriorates when the distance between the thermally conductive sheets is wide, it is desirable that the distance between the thermally conductive sheets is 0.1 mm to 5.0 mm. In the above limitation of the distance, it is preferable that the thickness of the thermally conductive sheets is 0.1 to 2.0 mm, and a material of the thermally conductive sheets and the direction in which the thermally conductive sheet is formed are not limited.

## Claims

1. A flat display apparatus, comprising
a display panel (410);
a frame (420, 520, 600, 720, 820) provided at a rear surface of the display panel; and
at least two thermally conductive sheets (430, 530, 730, 830) located between the display panel and the frame, the thermally conductive sheets being side-by-side and spaced apart from each other, **characterised in that** the thermally conductive sheets are porous sheets.

2. The flat display apparatus as claimed in claim 1, wherein the thermally conductive sheets (430, 530, 730, 830) have a smaller size than the size of the display panel (410), whereby edges of the thermally conductive sheets are spaced inwardly from an edge of the display panel.

3. The flat display apparatus as claimed in claim 1, wherein the distance between the thermally conductive sheets is 0.1 mm to 5.0 mm.

4. The flat display apparatus as claimed in claim 1, wherein the thermally conductive sheets have a thickness of 0.1 mm to 2.0 mm.

5. The flat display apparatus as claimed in claim 1, wherein the thermally conductive sheets (430, 530, 730, 830) are arranged in the direction which is a longitudinal direction or a widthwise direction of the frame (420, 520, 600, 720, 820).

6. The flat display apparatus as claimed in claim 1, wherein the porous sheets (430, 530, 730, 830) contain a foaming agent.

7. The flat display apparatus as claimed in claim 6, wherein the foaming agent comprises urethane foam.

8. The flat display apparatus as claimed in claim 7, wherein the porous sheets (430) contain silicon material.

9. The flat display apparatus as claimed in claim 1, wherein the frame (520, (600) has one or more holes (540, (610) therein.

10. The flat display apparatus as claimed in claim 1, wherein the thermally conductive sheets (730) and the frame (720) each have one or more holes (750, 740) located therein.

11. The flat display apparatus as claimed in claim 10, wherein the holes (740) formed in the thermally conductive sheets (730) are aligned with the hole (750) formed in the frame (720).

12. The flat display apparatus as claimed in claim 1, wherein the display panel is a plasma display panel.

13. A flat display apparatus as claimed in claim 1, wherein
a first region of the frame (520, 600, 720) has one or more holes (540, 610, 740) therein and
the thermally conductive sheet (530, 730, 830) is located at the first region of the frame.

14. The flat display apparatus as claimed in claim 13, wherein the thermally conductive sheet is a porous sheet containing a foam agent.

15. The flat display apparatus as claimed in claim 13, wherein the holes are disposed in an orderly pattern in the frame.

16. The flat display apparatus as claimed in claim 13, wherein the holes are disposed in a random pattern in the frame.

17. The flat display apparatus as claimed in claim 13, wherein each hole formed in the frame has a size of 0.1 mm to 10.0 mm.

18. The flat display apparatus as claimed in claim 13, wherein the thermally conductive sheet (730) has one or more holes (740) formed therein.

19. The flat display apparatus as claimed in claim 18, wherein each hole formed in the thermally conductive sheet has a size of 0.1 mm to 5.0 mm.

20. The flat display apparatus as claimed in claim 18, wherein the holes (740) formed in the thermally conductive sheet (730) are aligned with the holes (750) formed in the frame (720).

## Patentansprüche

1. Flachanzeigevorrichtung, die Folgendes aufweist:
ein Anzeigefeld (410),
einen Rahmen (420, 520, 600, 720, 820), der auf einer Rückseite des Anzeigefelds vorgesehen ist; und
mindestens zwei wärmeleitfähige Flächenkörper (430, 530, 730, 830), die zwischen dem Anzeigefeld und dem Rahmen angeordnet sind, wobei sich die wärmeleitfähigen Flächenkörper Seite an Seite befinden und voneinander beabstandet sind,
**dadurch gekennzeichnet, dass**
die wärmeleitfähigen Flächenkörper poröse Flächenkörper sind.

2. Flachanzeigevorrichtung nach Anspruch 1, wobei die wärmeleitfähigen Flächenkörper (430, 530, 730, 830) eine Größe haben, die kleiner ist als die Größe des Anzeigefelds (410), wodurch Ränder der wärmeleitfähigen Flächenkörper von einem Rand des Anzeigefelds nach innen beabstandet sind.

3. Flachanzeigevorrichtung nach Anspruch 1, wobei der Abstand zwischen den wärmeleitfähigen Flächenkörpern 0,1 mm bis 5,0 mm beträgt.

4. Flachanzeigevorrichtung nach Anspruch 1, wobei die wärmeleitfähigen Flächenkörper eine Dicke von 0,1 mm bis 2,0 mm haben.

5. Flachanzeigevorrichtung nach Anspruch 1, wobei die wärmeleitfähigen Flächenkörper (430, 530, 730, 830) in der Richtung angeordnet sind, die eine Längsrichtung oder eine Breitenrichtung des Rahmens (420, 520, 600, 720, 820) ist.

6. Flachanzeigevorrichtung nach Anspruch 1, wobei die porösen Flächenkörper (430, 530, 730, 830) ein Schaummittel enthalten.

7. Flachanzeigevorrichtung nach Anspruch 6, wobei das Schaummittel Urethanschaum umfasst.

8. Flachanzeigevorrichtung nach Anspruch 7, wobei die porösen Flächenkörper (430) ein Siliziummaterial enthalten.

9. Flachanzeigevorrichtung nach Anspruch 1, wobei der Rahmen (520, 600) ein Loch oder mehrere Löcher (540, 610) in sich aufweist.

10. Flachanzeigevorrichtung nach Anspruch 1, wobei die wärmeleitfähigen Flächenkörper (730) und der Rahmen (720) jeweils ein darin befindliches Loch oder mehrere darin befindliche Löcher (750, 740) aufweisen.

11. Flachanzeigevorrichtung nach Anspruch 10, wobei die Löcher (740), die in den wärmeleitfähigen Flächenkörpern (730) gebildet sind, mit den Löchern (750) ausgerichtet sind, die im Rahmen (720) gebildet sind.

12. Flachanzeigevorrichtung nach Anspruch 1, wobei das Anzeigefeld ein Plasma-Anzeigefeld ist.

13. Flachanzeigevorrichtung nach Anspruch 1, wobei ein erster Bereich des Rahmens (520, 600, 720) ein Loch oder mehrere Löcher (540, 610, 740) in sich aufweist, und
der wärmeleitfähige Flächenkörper (530, 730, 830) am ersten Bereich des Rahmens angeordnet ist.

14. Flachanzeigevorrichtung nach Anspruch 13, wobei der wärmeleitfähige Flächenkörper ein poröser Flächenkörper ist, der ein Schaummittel enthält.

15. Flachanzeigevorrichtung nach Anspruch 13, wobei die Löcher in einem geordneten Muster im Rahmen vorgesehen sind.

16. Flachanzeigevorrichtung nach Anspruch 13, wobei die Löcher in einem Zufallsmuster im Rahmen vorgesehen sind.

17. Flachanzeigevorrichtung nach Anspruch 13, wobei jedes Loch, das im Rahmen gebildet ist, eine Größe von 0,1 mm bis 10,0 mm hat.

18. Flachanzeigevorrichtung nach Anspruch 13, wobei der wärmeleitfähige Flächenkörper (730) ein darin gebildetes Loch (740) oder mehrere darin gebildete Löcher (740) aufweist.

19. Flachanzeigevorrichtung nach Anspruch 18, wobei jedes Loch, das im wärmeleitfähigen Flächenkörper gebildet ist, eine Größe von 0,1 mm bis 5,0 mm hat.

20. Flachanzeigevorrichtung nach Anspruch 18, wobei die Löcher (740), die im wärmeleitfähigen Flächenkörper (730) gebildet sind, mit den Löchern (750) ausgerichtet sind, die im Rahmen (720) gebildet sind.

## Revendications

1. Appareil formant écran plat, comprenant:
un panneau d'affichage (410);
un cadre (420, 520, 600, 720, 820) réalisé à une surface arrière du panneau d'affichage; et
au moins deux feuilles thermiquement conductrices (430, 530, 730, 830) situées entre le panneau d'affichage et le cadre, les feuilles thermiquement conductrices étant côte-à-côte et espacées les unes des autres,
**caractérisé en ce que** les feuilles thermiquement conductrices sont des feuilles poreuses.

2. Appareil formant écran plat selon la revendication 1, où les feuilles thermiquement conductrices (430, 530, 730, 830) ont une plus petite taille que la taille du panneau d'affichage (410), et de ce fait les bords des feuilles thermiquement conductrices sont espacés vers l'intérieur depuis un bord du panneau d'affichage.

3. Appareil formant écran plat selon la revendication 1, où la distance entre les feuilles thermiquement conductrices est de 0,1 mm à 5,0 mm.

4. Appareil formant écran plat selon la revendication 1, où les feuilles thermiquement conductrices ont une épaisseur de 0,1 mm à 2,0 mm.

5. Appareil formant écran plat selon la revendication 1, où les feuilles thermiquement conductrices (430, 530, 730, 830) sont agencées dans la direction qui est une direction longitudinale ou une direction dans le sens de la largeur du cadre (420, 520, 600, 720, 820).

6. Appareil formant écran plat selon la revendication 1, où les feuilles poreuses (430, 530, 730, 830) contiennent un agent de moussage.

7. Appareil formant écran plat selon la revendication 6, où l'agent de moussage comprend de la mousse d'uréthane.

8. Appareil formant écran plat selon la revendication 7, où les feuilles poreuses (430) contiennent du matériau de silicium.

9. Appareil formant écran plat selon la revendication 1, où le cadre (520, 600) présente un ou plusieurs trous (504, 610) dans celui-ci.

10. Appareil formant écran plat selon la revendication 1, où les feuilles thermiquement conductrices (730) et le cadre (720) ont chacun un ou plusieurs trous (750, 740) situés dans ceux-ci.

11. Appareil formant écran plat selon la revendication 10, où les trous (740) formés dans les feuilles thermiquement conductrices (730) sont alignés avec les trous (750) formés dans le cadre (720).

12. Appareil formant écran plat selon la revendication 1, où le panneau d'affichage est un panneau d'affichage à plasma.

13. Appareil formant écran plat selon la revendication 1, où une première région du cadre (520, 600, 720) présente un ou plusieurs trous (540, 610, 740) dans celle-ci, et
la feuille thermiquement conductrice (530, 730, 830) se situe à la première région du cadre.

14. Appareil formant écran plat selon la revendication 13, où la feuille thermiquement conductrice est une feuille poreuse contenant un agent moussant.

15. Appareil formant écran plat selon la revendication 13, où les trous sont disposés selon un motif ordonné dans le cadre.

16. Appareil formant écran plat selon la revendication 13, où les trous sont disposés selon un motif aléatoire dans le cadre.

17. Appareil formant écran plat selon la revendication 13, où chaque trou formé dans le cadre a une taille de 0,1 mm à 10,0 mm.

18. Appareil formant écran plat selon la revendication 13, où la feuille thermiquement conductrice (730) présente un ou plusieurs trous (740) formés dans celle-ci.

19. Appareil formant écran plat selon la revendication 18, où chaque trou formé dans la feuille thermiquement conductrice a une taille de 0,1 mm à 5,0 mm.

20. Appareil formant écran plat selon la revendication 18, où les trous (740) formés dans la feuille thermiquement conductrice (730) sont alignés avec les trous (750) ménagés dans le cadre (720).
